**Europäisches Patentamt**

(19) **European Patent Office** (11) Publication number: **0 142 557**

**Office européen des brevets** **B1**

---

(12) **EUROPEAN PATENT SPECIFICATION**

---

(45) Date of publication of the patent specification: (51) Int. Cl.⁴: **B 29 C 65/04,** B 65 D 5/28,
26.11.86 B 65 B 51/22

(21) Application number: **84902225.6**

(22) Date of filing: **15.05.84**

(86) International application number:
**PCT/SE 84/00183**

(87) International publication number:
**WO 84/04486 (22.11.84 Gazette 84/27)**

---

(54) **METHOD AND MEANS FOR JOINING AND SEALING OF MATERIAL PARTS AND USE OF SUCH MEANS IN CONTAINERS.**

---

(30) Priority: **19.05.83 SE 8302844**

(43) Date of publication of application:
**29.05.85 Bulletin 85/22**

(45) Publication of the grant of the patent:
**26.11.86 Bulletin 86/48**

(84) Designated Contracting States:
**AT BE CH DE FR GB LI LU NL**

(56) References cited:
**FR-A-1 022 460**
**FR-A-1 215 257**
**SE-A-8 007 721**
**SE-B-346 251**

(73) Proprietor: **Akerlund & Rausing Licens Aktiebolag,
Veddestavägen 7-9, S-175 62 Järfälla (SE)**

(72) Inventor: **BOGREN, Ingemar, Esselte Pac AB
Veddestavägen 7-9, S-175 62 Järfälla (SE)**

(74) Representative: **Avellan- Hultman, Olle, Avellan-
Hultman Patentbyra AB P.O. Box 5366, S-102 46
Stockholm 5 (SE)**

EP 0 142 557 B1

## Description

The present invention relates to a method and a means for joining and sealing of material parts, especially in the manufacture of containers. The invention also relates to the use of said apparatus in the manufacture of containers.

The invention has been developed especially in connection to the development of methods for the manufacture of containers of cardboard or a similar material, and in the following the invention will mainly be described in connection to the manufacture of such containers. It is, however, obvious that the invention is useful within many different technical fields and for the manufacture of containers of many different types of materials, and that the invention is not resricted to the manufacture of cardboard containers. So far different parts of the container generally have been glue connected for joining the container, and in such containers which at least on one surface has a layer of a weldable material the parts thereof generally have been weld-connected by using hot welding jaws. The gluing operation is time consuming and often gives an untight joint and when handling of glue there may be problems in keeping the container free from excess of glue since the glue sometimes must be heated before being applied and that the parts of the container must be pressed and cooled until the glue has become solidified. The joining of a container by means of hot welding jaws also is relatively time consuming in that the heat from the jaws must penetrate the cardboard layer and move as far as to the weldable layer of material. Also the welding heat of the jaws must be adapted to the specific material so that the cardboard material is not burnt or that the weldable material oxidizes or become coked. Also in case of constant heat welding there are pressing and cooling problems while the weldable layer of material solidifying. In later days joining and sealing of material parts, for instance parts of containers of cardboard or similar material has been made by means of micro waves, especially high frequence energy and ultrasonic energy. In this case the container material has been formed with a base or a body of cardboard, and an intermediate layer which can absorb higher frequence or ultrasonic especially aluminum, and an inner layer of a weldable material, preferably a resin material like polyethylene (US-A- 3 864 186). When joining and sealing parts of material the owerlapping portions of the container or two or more container parts are applied to each other and are maintained under some pressure, and high frequence or ultrasonic is supplied so that the energy thereof is absorbed by the conducting intermediate layer and provides a heating and malting of the weldable material layer.

Such a triple laminate comprising cardboard, aluminum and a resin is expensive to manufacture. For liquid and gas proof containers the material also must be formed so that no cut edges of the cardboard material are subjected to the gas or the liquid in the container both for the reason that cardboard material is not liquid or gas proof and also for the reason that the gas or liquid may be sucked into the cardboard layer thereby staining the material or extracting harmful substances thereof. When forming overlapped joints it is therefore often necessary to apply a special sealing layer over the cut edges of the cardboard material either in the form of a separate sealing strip or in that the cardboard material is removed, for instance by milling, so that the conducting intermediate layer and the weldable inner layer can be fold round the cut edge and be attached to the outer surface of the triple laminated material. This is an additionally expensive step in the container manufacture.

The basis of the invention therfore has been the problem of providing a method and an apparatus for joining and sealing of material parts, especially parts of containers of cardboard or a similar material in which the method and the apparatus can be used both for joining and for sealing of certain parts of the container whether the containers are of the non-sealing type or they are powder proof, liquid proof or gas proof.

According to the invention a joining piece comprising a laminate material including a heat receiving and heat conducting material and on one side or both sides thereof a heat-adhereable heat weldable layer is put with the weldable layer to the material parts to be joined or sealed, and the joining piece is pressed to said parts by a predetermined pressure and is subjected to high frequence or ultrasonic of such intensity and duration that the weldable layer melts and glue connects or welds the material parts together. The heating of the joining piece by means of high frequence or ultrasonic is made very quickly, often within the course of some second, and the heating thereby is made so quickly that there is not time enough for the cardboard material to be through heated. The method therefore is quick and very well can be utilized in packaging machines for continuous manufacture, filling and closing of containers.

The joining piece may be an endless strip which is cut into a suitable size in connection to joining of the container parts, but the joining piece also can be small or large pieces of material of any suitable size or shape, which are adapted to specific purposes, for instance sealing and also connection of certain parts of the container, discontinuous joining of material pieces, application of separate lids, labels and other pieces of material on the container.

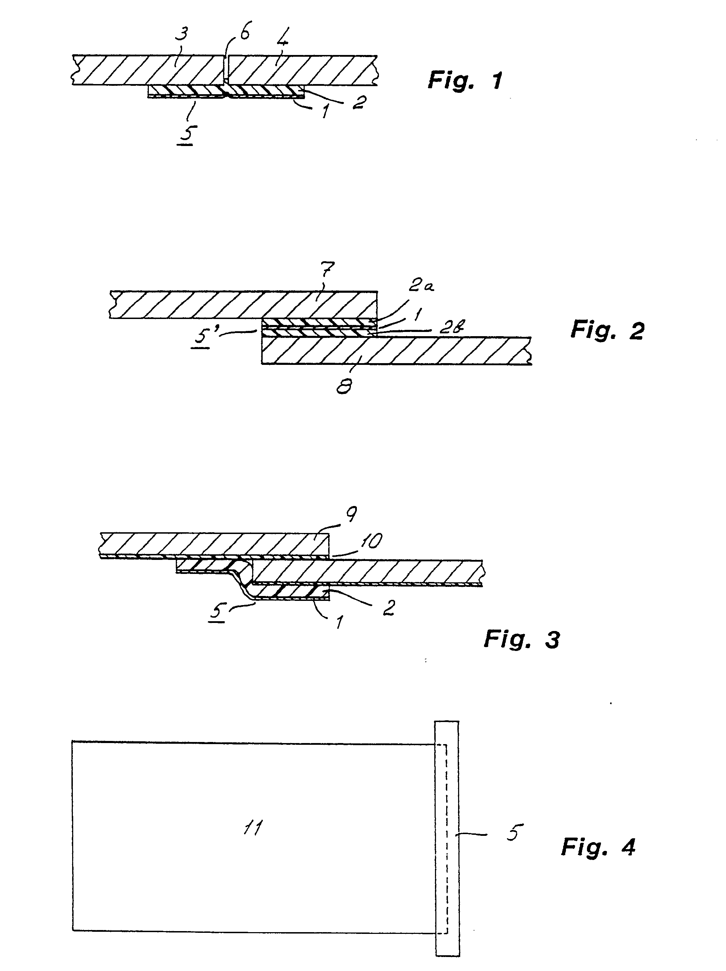

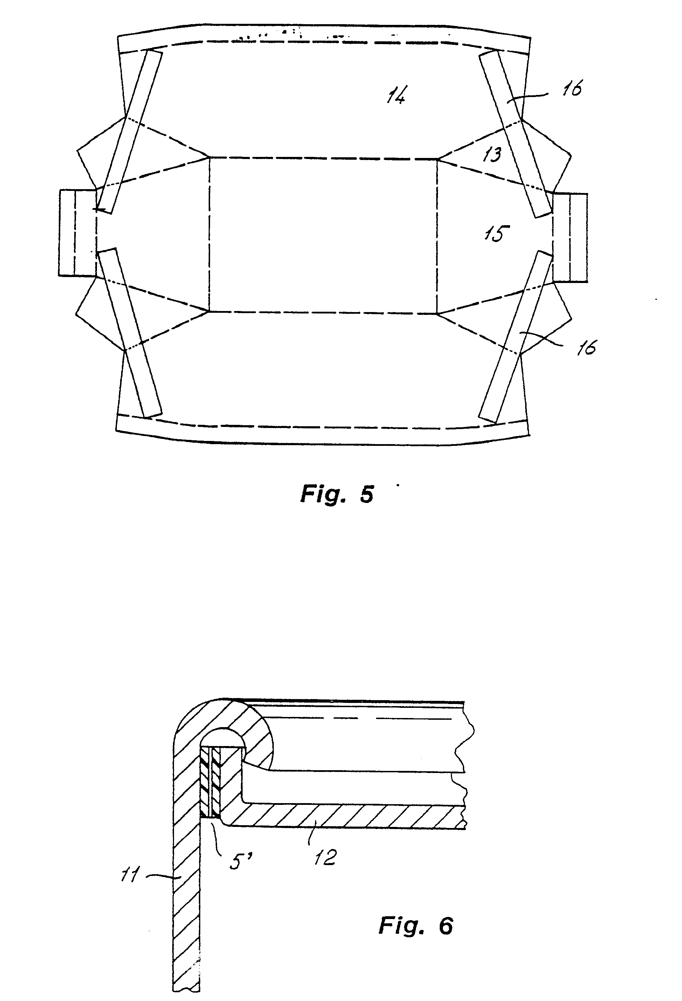

The invention now is to be described with reference to a few embodiments thereof and in connection to the accompanying drawings. In the drawings figure 11 diagrammatically shows a cross section through a so called butt joint of a container provided by the method and the apparatus according to the invention. Figure 2 shows an overlapped joint provided by means of an intermediate layer of a connection strip according to the invention, and figure 3 shows an overlapped joint provided by means of a covering joining strip according to the invention. Figure 4 shows a plain punched out container blank formed with a joining strip for enabling a joining to a tubular form of the container blank, figure 5 shows a joining strip according to the invention used for sealing of parts of a container, and figure 6 shows part of a ready filled and closed container.

A connection strip or a connection piece according to the invention comprises a material layer 1 which has the ability of receiving and being heated by high frequence or ultrasonic and to conduct such heat and at least on one side of said conductive layer 1 a layer 2 of a weldable material, preferably a weldable resin polyethylene. The conductive layer 1 preferably is an aluminum layer, but it may alternatively be of any other metal or any other material which has the ability of receiving and conducting high frequence or ultrasonic.

In figure 1 is shown the joining of two container parts 3 and 4, for instance joining of edges of cardboard to provide a container, and said joining is made by means of a joining strip 5 according to the invention. The joining is made by a so called butt joint in which the container parts 3 and 4 meat edge to edge. In figure 1 is shown in an exaggerated view there is a very little for instance a microscopically little space between the edges of the two container parts.

When joining the container parts 3 and 4 the connection strip 5 is put into contact with the two parts on the inner surface or the outer surface of the container, and a predetermined pressure is maintained between the parts whereupon high frequence or ultrasonic is supplied in the area of the connection strip. The high frequence energy or ultrasonic energy is absorbed in the conductive layer 1 thereby heating said layer which in turn heats the weldable or adhereable layer 2 in contact with the container parts 3 and 4, whereby said layer 2 is made soft or melts whereby the two container parts are welded together or glued together with the connection strip. As indicated in figure 1 the adhereing layer 2 may penetrate some distance inside the microscopically little space 6 thereby providing a good sealing and joining of the edges of the container parts.

Figure 2 shows a connection strip 5' comprising a central conductive layer 1 and on each side thereof a weldable or adhereable material layer 2a, 2b. A connection strip 5' of this type is intended to be used as a joining or sealing intermediate layer between the container parts 7, 8 overlaying each other, for instance an overlap joint of two cardboard parts. When applying high frequence or ultrasonic the energy thereof is absorbed by the central conductive layer 1 whereby the adhereable or weldable material layers 2a and 2b on each side of said conductive layer are heated, and the container parts 7 and 8 are glued or welded together.

Figure 3 shows an overlapped joint in a container made of a material having a base or body 9 of cardboard and an inner liquid proof plastic layer 10 and in which the overlapped joint is sealed by means of a connection strip 5 which is applied over the two overlapping container parts so that the sealing strip 5 provides a sealed longitudinal joint preventing any cut edge of the container material to be exposed to the packed fluid.

Figure 4 shows a plane punched out container blank 11, for instance a blank consisting of a cardboard plastic-laminate and intended for the manufacture of a container tube which upon filling and closing is formed with a top and a bottom closure. For joining the edges of the tube blank 11, a connection strip 5 is provided along one edge thereof, and after the blank is formed to tubular shape the longitudinal edges are welded or glued together in a butt joint as described in figure 1 or in an overlapped joint as shown in figure 3.

After the tube blank is formed to tubular form it may be closed, for instance as shown in figure 6, in which a top closure piece 12 is connected internally in the upper edge of the container tube by means of a connection strip 5' in the form of a plastic-metal-plastic laminate.

Figure 5 shows a plane blank for a container intended to be used for liquid or paste formed products like butter or margarine. In such a container it is important that the butter or the margarine does not move as far up as to the upper edge of the container. This easily occurs at the joining ears 13 shown between the container sides 14 and 15. For providing a seal against such penetrating butter or liquid a joining strip 16 therefore is applied across the joining ears 13, and said joining strip provides a sealing at the same time a joining of the joining ears 13 to the container sides 14 and 15.

As previously mentioned the joining strips may be bands or trips, for instance endless strips which are cut to a suitable length before or after the container sides are joined, but the connection pieces might as well be small pieces, for instance circular, square, triangular or similar joining pieces having a size and form adapting to its specific purpose.

It is to be understood that the above specification and the embodiments thereof shown in the drawings are only illustrated examples and that many different modifications may be presented within the scope of the following claims.

## Claims

1. Method of joining and sealing of material parts (3, 4, 7, 8, 11, 12) in particular parts of containers of cardboard or a similar material, characterized in that a joining piece (5, 5') comprising a laminate of a heat receiving and heat conducting layer of material (1) and on one or both sides thereof a heat adhesive or heat weldable layer (2) is put with the adhesive or weldable layer to the parts of the material to be joined and is pressed by means of predetermined pressure to said parts, whereupon the joining piece is subjected to a frequence or ultrasonic of such intensity and duration that the adhesive or weldable material layer or layers melt thereby gluing or welding the material parts together.

2. Method according to claim 1, characterized in that the joining piece (5, 5') is welded to the material parts using a resilient pressure.

3. Method according to claim 1 or 2, characterized in that the joining piece (5, 5') is shaped to strips or separate small pieces of material which are put over the area of material parts to be joined or sealed.

4. Method according to any of the preceding claims in which the joining piece is a triple laminate consisting of a central heat receiving and heat conducting material layer (1) and on each side thereof an adhesive or weldable material layer (2a, 2b) characterized in that the joining piece (5') is put between two material parts (7, 8, 11, 12, 13, 14, 15) to be joined, whereupon high frequence or ultrasonic is applied so that the material parts are glued or welded together.

5. Means for executing the method according to any of the preceding claims, characterized in that said means comprises a connection piece consisting of a laminate of a material layer (1) which is capable of absorbing and conducting high frequence energy, and one or more layers of an adhesive or weldable material (2).

6. Means according to claim 5, characterized in that the joining piece has an adhesive or weldable layer of material (2) only on one side thereof and is adapted for being put across the area to be joined or sealed.

7. Means according to claim 5, characterized in that the joining piece is a triple laminate having an adhesive or welda le layer of material (2a, 2b) on each side of the heat receivin and conducting material layer (1) and is intended to be put between two material parts (7, 8, 11, 12, 13, 14, 15) to be joined or sealed.

8. Means according to claims 5, 6 or 7, characterized in that the heat receiving and heat conducting material layer is a metal layer, preferably an aluminum layer, and in that the adhesive or weldable material layers (2, 2a, 2b) is a suitable synthetic resin material, for instance polyethylene.

9. Use of the means according to any of claims 5-8 in the manufacture joining and sealing of containers, in particular containers of cardboard or containers made of a material having a body or base of cardboard or any similar stiff material.

**Patentansprüche**

1. Verfahren zum Verbinden und Siegeln von Materialstücken (3, 4, 7, 8, 11, 12), insbesondere Teilen von Behältern aus Karton oder einem ähnlichen Material, dadurch gekennzeichnet, daß ein Verbindungsstück (5, 5'), welches ein Laminat aus einer wärmeaufnehmenden und wärmeleitenden Materialschicht (1) und auf deren einer oder beiden Seiten einer wärmehaftenden oder heißsiegelbaren Schicht (2) aufweist, mit der haftenden oder siegelbaren Schicht auf die zu verbindenden Materialteile gelegt und mit einem vorgegebenen Druck gegen die Teile gedrückt wird, worauf das Verbindungsstück einer Frequenz oder Ultraschall solcher Intensität und Dauer ausgesetzt wird, daß die haft- oder siegelfähige Materialschicht oder -schichten schmelzen, wodurch die Materialteile miteinander verklebt oder verschweißt werden.

2. Verfahren nach Anspruch 1, dadurch gekennzeichnet, daß das Verbindungsstücke (5, 5') mit den Materialteilen unter Verwendung eines federnden Drucks verschweißt werden.

3. Verfahren nach Anspruch 1 oder 2, dadurch gekennzeichnet, daß das Verbindungsstück (5, 5') in Streifen oder getrennten kleinen Materialstücken vorliegt, die über den Bereich von zu verbindenden oder zu siegelnden Materialteilen gelegt werden.

4. Verfahren nach einem der vorhergehenden Ansprüche, bei dem das Verbindungsstück ein Dreifachlaminat aus einer mittleren wärmeaufnehmenden und wärmeleitenden Materialschicht (1) und beidseitig einer haftfähigen oder schweißfähigen Materialschicht (2a, 2b) ist, dadurch gekennzeichnet, daß das Verbindungsstück (5') zwischen zwei zu verbindende Materialstücke (7, 8, 11, 12, 13, 14, 15) gelegt wird, worauf Hochfrequenz oder Ultraschall angelegt wird, so daß die Materialstücke zusammengeklebt oder -geschweißt werden.

5. Mittel zur Ausführung des Verfahrens nach einem der vorhergehenden Ansprüche, dadurch gekennzeichnet, daß das Mittel ein Verbindungsstück aus einem Laminat aufweist, das aus einer Hochfrequenzenergie absorbierenden und leitenden Materialschicht (1) und einer oder mehreren Schichten aus einem haft- oder siegelfähigem Material (2) besteht.

6. Mittel nach Anspruch 5, dadurch gekennzeichnet, daß das Verbindungsstück nur auf einer Seite mit einer haftenden oder schweißfähigen Materialschicht (2) versehen und über einen zu verbindenden oder zu siegelnden Bereich legbar ist.

7. Mittel nach Anspruch 5, dadurch gekennzeichnet, daß das Verbindungsstück ein Dreifachlaminat mit einer haftfähigen oder schweißbaren Materialschicht (2a, 2b) auf beiden Seiten der wärmeaufnehmenden und -leitenden Materialschicht (1) ist und zum Einlegen zwischen zwei zu verbindenden oder zu siegelnden Materialstücken (7, 8, 11, 12, 13, 14, 15) vorgesehen ist.

8. Mittel nach Anspruch 5, 6 oder 7, dadurch gekennzeichnet, daß die wärmeaufnehmende und wärmeleitende Materialschicht eine Metallschicht, vorzugsweise eine Aluminiumschicht ist und daß die haftfähigen oder schweißfähigen Materialschichten (2, 2a, 2b) aus einem geeigneten Kunststoffmaterial, beispielsweise aus Polyäthylen bestehen.

9. Verwendung des Mittels nach einem der Ansprüche 5 bis 8, beim Verbinden und Siegeln von Behältern, insbesondere von Behältern aus Karton oder Behältern aus einem Material mit einem Körper oder einer Basis aus Karton oder ähnlich steifem Material.

**Revendications**

1. Procédé pour assembler et sceller des pièces (3, 4, 7, 8, 11, 12) de matière en pièces particulières de conteneurs en carton ou en matière similaire, caractérisé en ce qu'un élément (5, 5') d'assemblage, comprenant un stratifié d'une couche de matière (1) de réception de la chaleur et de conduction de la chaleur et, sur l'une de ses faces ou sur ses deux faces, d'une couche thermo-adhésive ou thermosoudable (2), est appliqué avec la couche adhésive ou soudable sur les pièces de la matière à assembler et est pressé au moyen d'une pression prédéterminée sur lesdites pièces, après quoi l'élément d'assemblage est soumis à une fréquence ou des ultrasons d'une intensité et d'une durée telles que la couche ou les couches de matière adhésive ou soudable fondent, collant ou soudant ainsi les pièces de matière entre elles.

2. Procédé selon la revendication 1, caractérisé en ce que l'élément (5, 5') d'assemblage est soudé aux pièces de matière sous une pression élastique.

3. Procédé selon la revendication 1 ou 2, caractérisé en ce que l'élément d'assemblage (5, 5') est façonné en bandes ou en petits éléments séparés de matière qui sont placés sur la zone des pièces de matière à assembler ou sceller.

4. Procédé selon l'une quelconque des revendications précédentes, dans lequel l'élément d'assemblage est un stratifié triple constitué d'une couche centrale (1) de matière de réception de la chaleur et de conduction de la chaleur et, sur chacune de ses faces, d'une couche (2a, 2b) de matière adhésive ou soudable, caractérisé en ce que l'élément d'assemblage (5') est placé entre deux pièces de matière (7, 8, 11, 12, 13, 14, 15) à assembler, après quoi une haute fréquence ou des ultrasons sont appliqués afin que les pièces de matière soient collées ou soudées entre elles.

5. Moyen pour la mise en oeuvre du procédé selon l'une quelconque des revendications précédentes, caractérisé en ce que lesdits moyens comprennent un élément de liaison constitué d'un stratifié d'une couche (1) de matière qui est capable d'absorber et de conduire de l'énergie à haute fréquence et d'une ou plusieurs couches d'une matière adhésive ou soudable (2).

6. Moyen selon la revendication 5, caractérisé en ce que l'élément d'assemblage comporte une couche de matière adhésive ou soudable (2) sur une seule de ses faces et est conçu pour être placé en travers de la zone à assembler ou sceller.

7. Moyen selon la revendication 5, caractérisé en ce que l'élément d'assemblage est un stratifié triple comportant une couche de matière adhésive ou soudable (2a, 2b) sur chaque face de la couche (1) de matière de réception et de conduction de la chaleur et est destiné à être placé entre deux pièces de matière (7, 8, 11, 12, 13, 14, 15) à assembler ou sceller.

8. Moyen selon les revendications 5, 6 ou 7, caractérisé en ce que la couche de matière de réception de la chaleur et de conduction de la chaleur est une couche de métal, avantageusement une couche d'aluminium, et en ce que les couches de matière adhésive ou soudable (2, 2a, 2b) sont en une matière résineuse synthétique convenable, par exemple du polyéthylène.

9. Utilisation des moyens selon l'une quelconque des revendications 5-8 dans l'assemblage et le scellage pour la fabrication de conteneurs, en particulier des conteneurs en carton ou des conteneurs réalisés en une matière ayant un corps ou une base de carton ou toute autre matière rigide similaire.

Fig. 1

Fig. 2

Fig. 3

Fig. 4

**Fig. 5**

**Fig. 6**